# EUROPÄISCHE PATENTANMELDUNG

(11) **EP 1 956 710 A1**
(43) Veröffentlichungstag der Anmeldung: **13.08.2008**
(21) Anmeldenummer: 07111897.0
(22) Anmeldetag: 06.07.2007
(51) Int. Cl.: H03K 17/74

(54) **Elektronische Schaltung für einen Hochfrequenzschalter**

(30) Priorität: 02.02.2007 DE 102007006100
(71) Anmelder: Feig Electronic GmbH, 35781 Weilburg-Waldhausen (DE)
(72) Erfinder: Wennrich, Andreas, 65554 Limburg (DE)
(74) Vertreter: Knefel, Cordula

(57) **Zusammenfassung**

Elektronische Schaltung für einen Hochfrequenzschalter (14) zum Öffnen einer Antennenschleife eines RFID-Systems, wobei der Hochfrequenzschalter über Gleichspannungen geöffnet und geschlossen werden kann, bei der
- eine Gleichrichterschaltung (10) die Sperrspannung zum Öffnen des Hochfrequenzschalters (14) aus der speisenden Hochfrequenzspannung erzeugt,
- die Gleichrichterschaltung (10) so ausgelegt ist, dass sie eine Sperrspannung erzeugt, deren Betrag mindestens dem Spitzenwert der zu schaltenden Hochfrequenzspannung entspricht,
- die Sperrspannung über dieselbe elektrische Verbindungsleitung (a) geführt wird, über die auch die speisende Hochfrequenzspannung und die Schließspannung zur Antenne des RFID-Systems geführt wird,
- zu den gleichstrommäßig in Reihe geschalteten PIN-Dioden (V1,V2) jeweils ein hochohmiger Widerstand (R3,R4) parallel geschaltet ist.

## Beschreibung

Die Erfindung betrifft eine elektronische Schaltung für einen Hochfrequenzschalter zum Öffnen einer Antennenschleife eines RFID-Systems.

Die Erfindung bezieht sich auf einen Hochfrequenzschalter ab 1 Megahertz (MHz), der Leistungen von beispielsweise 15 Watt (W) bei Spannungen von 500 Volt (V) und Strömen von 2 Ampere (A) schalten kann.

Diese elektrischen Größen können zum Beispiel an den Antennen eines RFID-Systems auftreten, bei denen der Abstand zwischen den Transpondern und der Antenne des RFID-Systems eine Distanz von 0,5 Metern überschreitet.

Die Antenne eines RFID-Systems besteht gemäß dem Stand der Technik in der Regel aus mindestens einer Antennenschleife, die eine Induktivität darstellt, und einer Anpassschaltung, mit deren Hilfe die Antenne möglichst gut auf die Betriebsfrequenz des RFID-Systems abgestimmt werden kann, um einen hohen Strom und damit eine hohe magnetische Feldstärke zu erzielen.

Häufig werden RFID-Systeme gemäß dem Stand der Technik mit mehreren Antennen betrieben, wobei die Trägerfrequenz von beispielsweise 13,56 MHz von einer zu einer anderen Antenne umgeschaltet wird. Dies kann zum Beispiel mit so genannten Multiplexern erfolgen. Derartige Anwendungen von RFID-Systemen werden beispielsweise in der DE 100 56 176 C1 und EP 1 618 750 A1 beschrieben. Abhängig von der Bauart, Größe und Anordnung der einzelnen Antennen entsteht aufgrund elektromagnetischer Felder eine mehr oder weniger hohe elektromagnetische Kopplung zwischen den einzelnen Antennen, wobei die elektromagnetischen Felder der gerade aktiven Antenne in benachbarten, inaktiven Antennen einkoppeln. Diese Kopplung der aktiven und inaktiven Antennen bewirkt eine Veränderung der Resonanzfrequenz des Antennenschwingkreises der aktiven Antennen und hat Verlustleistungen zur Folge, durch die nicht mehr die volle Leistung der aktiven Antenne zur Kommunikation mit Transpondern zur Verfügung steht.

Eine effektive Art zur Vermeidung einer gegenseitigen Kopplung von Antennen eines RFID-Systems wird erreicht, indem die Antennenschleife und damit der Antennenschwingkreis der inaktiven Antennen durch einen Schalter geöffnet wird. Ein Hochfrequenzschalter zum Öffnen von inaktiven Antennen wird in der DE 10 2005 013 123 A1 beschrieben, wobei in der dort beschriebenen Schaltung die Spannung zum Öffnen des aus PIN-Dioden aufgebauten Hochfrequenzschalters aus der eingekoppelten Spannung einer benachbarten Antenne erzeugt wird.

Das der Erfindung zugrunde liegende technische Problem besteht darin, eine verbesserte Ausführungsform eines Hochfrequenzschalters und eine elektronische Schaltung für einen Hochfrequenzschalter anzugeben, mit dem eine Anntennenschleife eines RFID-Systems vollständig geöffnet werden kann und damit für die eingekoppelte Hochfrequenzspannung einen näherungsweise vollständig geöffneten Schalter darstellt.

Dieses technische Problem wird durch die elektronische Schaltung mit den Merkmalen des Anspruches 1 gelöst.

Die erfindungsgemäße elektronische Schaltung für einen Hochfrequenzschalter zum Öffnen einer Antennenschleife eines RFID-Systems, wobei der Hochfrequenzschalter, der aus mindestens zwei PIN-Dioden aufgebaut ist, über Gleichspannungen geöffnet und geschlossen werden kann, zeichnet sich dadurch aus, dass
- eine Gleichrichterschaltung, die außerhalb des Antennenschwingkreises angeordnet ist, die Sperrspannung zum Öffnen des Hochfrequenzschalters aus der speisenden Hochfrequenzspannung erzeugt, wobei der Abgriff der Gleichrichterschaltung gleichstrommäßig entkoppelt ist, und
- die Gleichrichterschaltung so ausgelegt ist, dass sie eine Sperrspannung erzeugt, deren Betrag mindestens dem Spitzenwert der zu schaltenden Hochfrequenzspannung entspricht, und
- die Sperrspannung über dieselbe elektrische Verbindungsleitung geführt wird, über die auch die speisende Hochfrequenzspannung und die Schließspannung zur Antenne des RFID-Systems geführt wird, wobei die Einspeisung der Sperrspannung hochohmig erfolgt, und
- zu den gleichstrommäßig in Reihe geschalteten PIN-Dioden jeweils ein hochohmige Widerstand parallel geschaltet ist.

Ferner gewährleistet die Erfindung, dass die Spannungen zur Steuerung des Hochfrequenzschalters und die speisende Hochfrequenzspannung über dieselbe Verbindungsleitung geführt werden.

Erfindungsgemäß ist hierzu die Verwendung eines Hochfrequenzschalters aus PIN-Dioden vorgesehen, wobei die PIN-Dioden mit Hilfe einer negativen Gleichspannung gesperrt werden können, die im Folgenden als Sperrspannung bezeichnet wird. Der Betrag der Sperrspannung muss mindestens so hoch sein, wie der Spitzenwert der zu schaltenden Hochfrequenzspannung, wobei der Spitzenwert der zu schaltenden Hochfrequenzspannung durch die eingekoppelte Hochfrequenzspannung bestimmt wird, deren Spitzenwert den der speisenden Hochfrequenzspannung um ein mehrfaches übersteigen kann.

Um den Hochfrequenzschalter wieder zu schließen, wird eine weitere Gleichspannung, die im Folgenden als Schließspannung bezeichnet wird, benötigt, die gegenüber der Sperrspannung eine positive Gleichspannung ist, deren Betrag aber sehr viel geringer sein kann als die Sperrspannung. Die Schließspannung kann beispielsweise von einer Schreib-/Lesestation, einem Multiplexer oder von einer Antennenanpassschaltung erzeugt werden.

Die erfindungsgemäße Schaltung gewährleistet, dass eine ausreichend hohe Sperrspannung erzeugt wird, um die PIN-Dioden des Hochfrequenzschalters vollständig zu sperren, und die es ermöglicht, dass die Sperrspannung über dieselbe elektrische Verbindungsleitung zur Antenne geführt wird, über die auch die speisende Hochfrequenzspannung und die Schließspannung zur Antenne geführt wird.

Dazu wird die Sperrspannung mit Hilfe einer Gleichrichterschaltung aus der speisenden Hochfrequenzspannung erzeugt. Je nach Höhe der benötigten Sperrspannung kann die Gleichrichterschaltung auch als Spannungsverdopplungs- oder Spannungsvervielfachungsschaltung, wie beispielsweise als Villard-Schaltung ausgeführt sein. Die Höhe der benötigten Sperrspannung kann von mehreren Parametern abhängen, wie zum Beispiel der Kopplung zwischen einem aktiven Antennenschwingkreis und dem zu öffnenden Antennenschwingkreis oder der Dauer, für die der PIN-Diodenschalter geöffnet sein soll.

Die Einspeisung der speisenden Hochfrequenzspannung in die Gleichrichterschaltung erfolgt dabei außerhalb des Antennenschwingkreises, da an dieser Stelle nicht die hohen Spannungen wie am Hochfrequenzschalter selbst auftreten. Um die Schließspannung nicht mit der Gleichrichterschaltung zu belasten, wird die Einspeisung der Hochfrequenzspannung gleichspannungsmäßig entkoppelt, wozu zum Beispiel ein Kondensator verwendet wird. Da die Gleichrichterschaltung für die speisende Hochfrequenzspannung eine Last darstellt, ist sie hochohmiger gegenüber der angeschlossenen Antenne ausgeführt.

Damit die Sperrspannung an allen PIN-Dioden anliegt, ist es erfindungsgemäß vorgesehen, je einen hochohmigen Widerstand parallel zu jeder PIN-Diode zu schalten, über die sich die Sperrspannung auf alle PIN-Dioden aufteilt.

Erfindungsgemäß wird die von der Gleichrichterschaltung erzeugte Sperrspannung ebenfalls außerhalb des Antennenschwingkreises in die speisende Hochfrequenzspannung eingespeist. Hierbei ist es vorteilhaft, die Sperrspannung hochohmig anzukoppeln, damit wiederum die speisende Hochfrequenzspannung und die Schließspannung durch die Gleichrichterschaltung so wenig wie möglich belastet werden.

Damit der Hochfrequenzschalter auch für einen langen Zeitraum sicher im geöffneten Zustand verbleibt, wird die Sperrspannung in einer weiteren vorteilhaften Ausführungsform in einem Pufferkondensator mit einer sehr hohen Kapazität gepuffert. Der geöffnete Hochfrequenzschalter stellt dabei eine sehr hochohmige Lastimpedanz dar. Die hohe Kapazität in Verbindung mit der hochohmigen Lastimpedanz des Hochfrequenzschalters ergibt eine lange Entladezeit des Pufferkondensators. Die erforderliche Entladezeit hängt wie die Höhe der Sperrspannung von mehreren Parametern, wie zum Beispiel der Kopplung zwischen einem benachbarten aktiven Antennenschwingkreis und dem zu öffnenden Antennenschwingkreis oder der Dauer, für den der Hochfrequenzschalter geöffnet sein soll, ab. Sind die Schließspannung und die speisende Hochfrequenzspannung aktiviert, wird der Pufferkondensator geladen. Wird die Schließspannung und die speisende Hochfrequenzspannung abgeschaltet, wird der Pufferkondensator langsam entladen und stellt die Sperrspannung für den PIN-Diodenschalter zur Verfügung.

In einer weiteren vorteilhaften Ausführungsform wird eine Entkoppelschaltung angegeben, die verhindert, dass die unter Umständen hohe Sperrspannung andere, mit der erfindungsgemäßen Schaltung elektrisch verbundene Komponenten, wie zum Beispiel eine Schreib-/Lesestation oder einen Multiplexer, beeinträchtigen oder beschädigen kann.

In der Entkoppelschaltung wird die speisende Hochfrequenzspannung über einen Kondensator, der für die verwendete Hochfrequenz sehr niederohmig ist, geführt. Parallel zu dem Kondensator liegt eine Induktivität, die für die verwendete Hochfrequenz sehr hochohmig ist. In Reihe zu der Induktivität ist ein Schalter vorgesehen, der zum Beispiel ein Transistorschalter oder ein Optokoppler sein kann, und der durch das Anlegen der Schließspannung geschlossen wird. Liegt die Schließspannung nicht mehr an, öffnet sich der Schalter und wird damit sehr hochohmig für die Sperrspannung, so dass eine Entladung der Sperrspannung über die Entkoppelschaltung so gut wie ausgeschlossen wird.

Weitere Merkmale und Vorteile der Erfindung ergeben sich anhand der zugehörigen Zeichnung, in der mehrere Ausführungsbeispiele einer erfindungsgemäßen Schaltung nur beispielhaft dargestellt sind. In der Zeichnung zeigen:
- Fig.1: ein Blockschaltbild mit dem prinzipiellen Aufbau aus Hochfrequenzschalter, Sperrspannungserzeugung und Steuerspannung;
- Fig. 2: ein Blockschaltbild der Schaltung zum Erzeugen und Einspeisen der Sperrspannung;
- Fig. 3: ein Schaltbild des Hochfrequenzschalters mit zusätzlichen Widerständen;
- Fig. 4: ein Blockschaltbild mit Entkoppelschaltung.

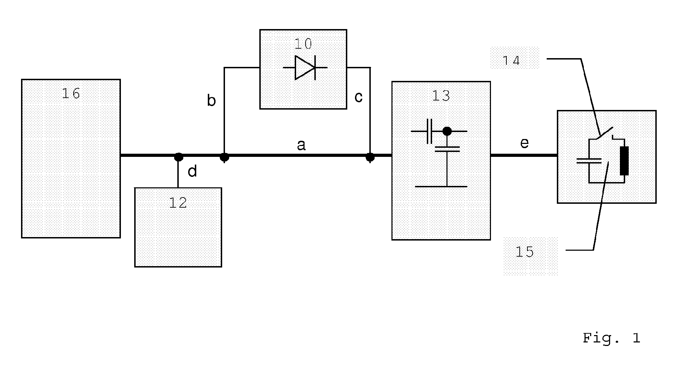

Fig. 1 zeigt einen prinzipiellen Aufbau einer Schaltungsanordnung bestehend aus einer Schreib-/Lesestation (16), einem Hochfrequenzschalter (14), der Bestandteil eines Schwingkreises (15) einer Antenne eines RFID-Systems ist, und einer Anpassschaltung (13) sowie einer Gleichrichterschaltung (10) zur Erzeugung der Sperrspannung und einer Vorrichtung zur Erzeugung der Schließspannung (12).

Um den Schwingkreis (15) mit dem Hochfrequenzschalter (14) zu schließen, wird die Schließspannung über eine Verbindungsleitung (d) auf eine Hochfrequenzverbindungsleitung (a) eingespeist.

Die Einspeisung der Hochfrequenzspannung zum Schwingkreis (15) erfolgt durch die Schreib-/Lesestation (16). Über eine Verbindungsleitung (b) wird aus der speisenden Hochfrequenzspannung die Spannung zur Speisung der Gleichrichterschaltung (10), die zur Erzeugung der Sperrspannung dient, abgegriffen. Die in die Gleichrichterschaltung (10) eingespeiste Hochfrequenzspannung wird dort durch eine Gleichrichterschaltung auf den benötigten Betrag zum Sperren des Hochfrequenzschalters (14) gebracht. Die Sperrspannung wird über eine Verbindungsleitung (c) eingespeist und über die Verbindungsleitungen (a) und (e) zum Hochfrequenzschalter (14) geleitet.

Die Steuerung, ob der Hochfrequenzschalter (14) geöffnet oder geschlossen werden soll, erfolgt über die Schließspannung, die über die Vorrichtung (12), die beispielsweise auch ein Bestandteil der Schreib-/Lesestation (16) sein kann, eingespeist wird. Sobald die Schließspannung abgeschaltet wird, wird der Hochfrequenzschalter (14) durch die in der Gleichrichterschaltung (10) erzeugte Sperrspannung geöffnet.

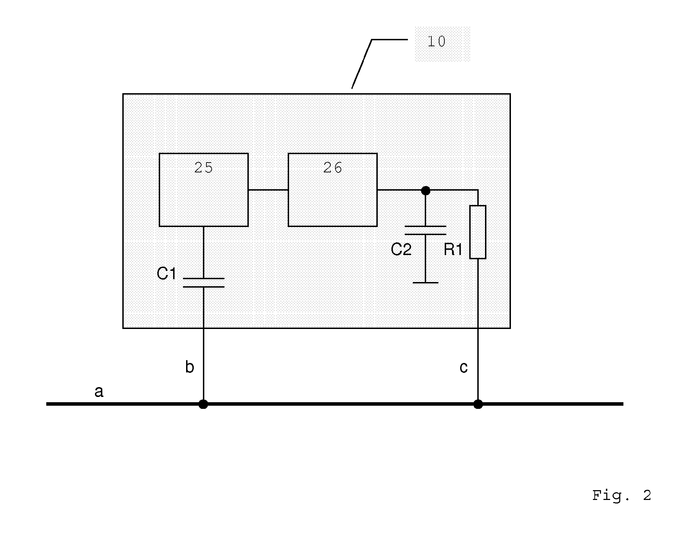

Fig. 2 zeigt eine Ausführungsform einer Gleichrichterschaltung (10) zur Erzeugung und Einspeisung der Sperrspannung, der die Hochfrequenzspannung über einem Koppelkondensator (C1), der für die Hochfrequenzspannung sehr niederohmig ist, zugeführt wird. Eine Gleichrichtung (26) ist über ein Bandfilter (25) mit dem Koppelkondensator (C1) verbunden. Das Bandfilter (25) verhindert das Aufmodulieren von Oberwellen auf die speisende Hochfrequenzspannung, die durch die Gleichrichtung (26) entstehen können.

Am Ausgang der Gleichrichtung (26), die je nach benötigter Höhe der Sperrspannung zum Beispiel als Einweggleichrichtung oder Villard-Schaltung ausgeführt sein kann, wird die erzeugte Sperrspannung mit einem Pufferkondensator (C2) mit hoher Kapazität gepuffert. Ein hochohmiger Lastwiderstand (R1) am Ausgang der Gleichrichtung (26) stabilisiert zusammen mit dem Pufferkondensator (C2) die Sperrspannung und verhindert durch seinen Widerstandswert, der in Relation zum Gleichstromwiderstand des geschlossenen Hochfrequenzschalters hoch ist, dass die Schließspannung durch den Ausgang der Gleichrichterschaltung (10) zu stark belastet wird.

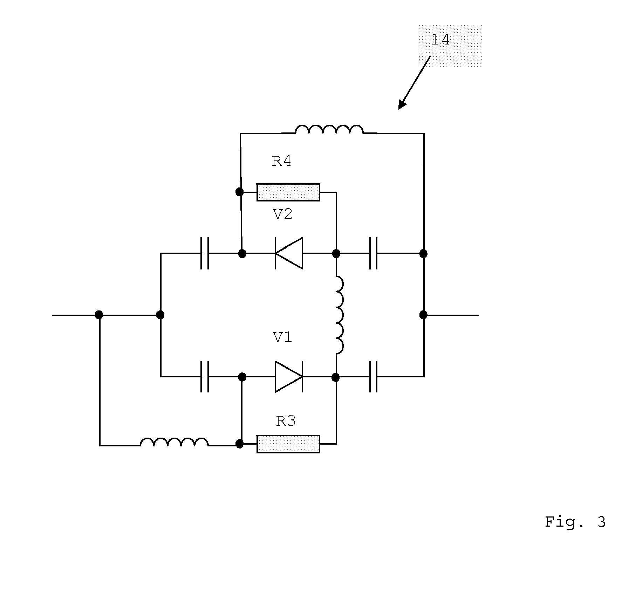

Fig. 3 zeigt den Aufbau des Hochfrequenzschalters (14) mit zwei PIN-Dioden (V1, V2). Dabei sind gleichgroße, hochohmige Widerstände (R3, R4) jeweils parallel zu den gleichstrommäßig in Reihe geschalteten PIN-Dioden (V1, V2) geschaltet. Die Sperrspannung teilt sich dadurch auf beide PIN-Dioden (V1, V2) gleichmäßig auf, so dass beide gesperrt werden können.

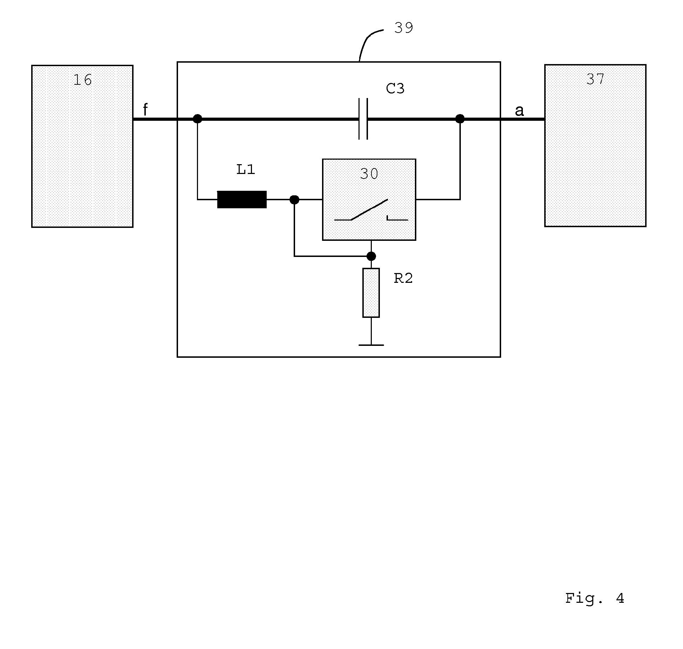

Fig. 4 zeigt ein Blockschaltbild einer Ausführungsform der Erfindung, bei der durch Einsatz einer Entkoppelschaltung (39) eine Rückwirkung der Sperrspannung auf die beispielhaft dargestellte Schreib-/Lesestation (16) verhindert wird, die es aber erlaubt, die Schließspannung von der Schreib-/Lesestation (16) zu einer Antennenbaugruppe (37) über dieselbe Leitung (a, f) zu führen, über die auch die die Antenne speisende Hochfrequenzspannung geleitet wird. Gleichzeitig gewährleistet die Schaltung, dass die gleichstrommäßige Verbindung zwischen Schreib-/Lesestation (16) und Antennenbaugruppe (37) automatisch getrennt wird, sobald keine Schließspannung mehr von der Schreib-/Lesestation (16) anliegt. Die Antennenbaugruppe (37) beinhaltet in diesem Fall die Komponenten Gleichrichterschaltung (10), Anpassschaltung (13), Hochfrequenzschalter (14) und Schwingkreis (15).

Die Entkoppelschaltung (39) besteht in diesem Ausführungsbeispiel aus einem Schalter (30), der zum Beispiel als Transistorschalter oder Optokoppler ausgeführt sein kann, einem Kondensator (C3), einer Induktivität (Spule) (L1) und einem Widerstand (R1). Liegt eine Schließspannung über eine Verbindungsleitung (f) an, so wird der Schalter (30) geschlossen, so dass die Gleichspannung an die Verbindungsleitung (a) gelangen kann. Wird die Schließspannung abgeschaltet, so öffnet der Schalter (30) die gleichstrommäßige Verbindung und die hohe Sperrspannung, die über die Verbindungsleitung (a) an der Entkoppelschaltung (39) anliegt, wird von dem weiteren Gerät getrennt. Der Kondensator (C3) stellt die hochfrequenzspannungsmäßige Verbindung dar, während die Induktivität (L1) gewährleistet, dass die Hochfrequenzspannung nicht über den Widerstand (R2) belastet wird. Der Widerstand (R2) ist so hochohmig, dass er ebenfalls die Schließspannung so wenig wie möglich belastet.

### Bezugszahlen

- 10: Gleichrichterschaltung
- 12: Vorrichtung zur Erzeugung einer Schließspannung
- 13: Anpassschaltung
- 14: Hochfrequenzschalter
- 15: Schwingkreis
- 16: Schreib-/Lesestation
- 25: Filterschaltung
- 26: Gleichrichtung
- 30: Schalter
- 37: Antennenbaugruppe
- 39: Entkoppelschaltung
- a: Verbindungsleitung
- b: Verbindungsleitung
- c: Verbindungsleitung
- d: Verbindungsleitung
- e: Verbindungsleitung
- f: Verbindungsleitung
- C1: Kondensator
- C2: Kondensator
- C3: Kondensator
- R1: Widerstand
- R2: Widerstand
- R3: Widerstand
- R4: Widerstand
- L1: Spule
- V1: PIN-Diode
- V2: PIN-Diode

## Patentansprüche

1. Elektronische Schaltung für einen Hochfrequenzschalter zum Öffnen einer Antennenschleife eines RFID-Systems, wobei der Hochfrequenzschalter, der aus mindestens zwei PIN-Dioden aufgebaut ist, über Gleichspannungen geöffnet und geschlossen werden kann,
**dadurch gekennzeichnet, dass**
- eine Gleichrichterschaltung (10), die außerhalb des Antennenschwingkreises angeordnet ist, die Sperrspannung zum Öffnen des Hochfrequenzschalters (14) aus der speisenden Hochfrequenzspannung erzeugt, wobei der Abgriff der Gleichrichterschaltung (10) gleichstrommäßig entkoppelt ist, und
- die Gleichrichterschaltung (10) so ausgelegt ist, dass sie eine Sperrspannung erzeugt, deren Betrag mindestens dem Spitzenwert der zu schaltenden Hochfrequenzspannung entspricht, und
- die Sperrspannung über dieselbe elektrische Verbindungsleitung (a) geführt wird, über die auch die speisende Hochfrequenzspannung und die Schließspannung zur Antenne des RFID-Systems geführt wird, wobei die Einspeisung der Sperrspannung hochohmig erfolgt, und
- zu den gleichstrommäßig in Reihe geschalteten PIN-Dioden (V1, V2) jeweils ein hochohmiger Widerstand (R3, R4) parallel geschaltet ist.

2. Elektrische Schaltung nach Anspruch 1, **dadurch gekennzeichnet, dass** die Gleichrichterschaltung (10) zur Erzeugung der Sperrspannung eine Einweggleichrichterschaltung ist.

3. Elektrische Schaltung nach Anspruch 1, **dadurch gekennzeichnet, dass** die Gleichrichterschaltung (10) zur Erzeugung der Sperrspannung eine Spannungsvervielfachungsschaltung ist.

4. Elektrische Schaltung nach Anspruch 1, **dadurch gekennzeichnet, dass** eine hohe Kapazität (C2) zur Erhaltung der Sperrspannung mindestens für die erforderliche Dauer vorgesehen ist.

5. Elektrische Schaltung nach einem der vorherigen Ansprüche, **dadurch gekennzeichnet, dass** eine Entkoppelschaltung (39) vorgesehen ist, die als eine das Entladen der Sperrspannung über die Verbindungsleitung (a, f) verhindernde Entkoppelschaltung (39) ausgebildet ist.
